Europäisches Patentamt

European Patent Office

Office européen des brevets

(11) Publication number: **0 309 147**
A2

# EUROPEAN PATENT APPLICATION

(21) Application number: 88308514.4

(51) Int. Cl.⁴ **H01L 41/02**

(22) Date of filing: **15.09.88**

(30) Priority: **19.09.87 GB 8722086**

(43) Date of publication of application:
**29.03.89 Bulletin 89/13**

(84) Designated Contracting States:
**AT CH DE ES FR GB GR IT LI NL SE**

(71) Applicant: **AM INTERNATIONAL INCORPORATED**
**333 West Wacker Drive Suite 900**
**Chicago Illinois 60606-1265(US)**

(72) Inventor: **Michaelis, Alan John**
**1800 Bruning Drive West**
**Itasca Illinois 60143(US)**

(74) Representative: **Coleman, Stanley et al**
**MATHYS & SQUIRE 10 Fleet Street**
**London EC4Y 1AY(GB)**

(54) Monolithic piezoelectric bimorph.

(57) A piezoelectric bimorph is formed by uniformly poling a homogeneous sheet of piezoelectric material in a first direction and thereafter establishing a substantially linear temperature gradient across the sheet while concurrently applying a reverse poling field across the sheet of a magnitude selected for substantially depoling the middle layers of the sheet, poling the hotter layers in the reverse direction and leaving the cooler layers poled in the first direction. The impedance of the piezoelectric material is monitored to terminate reverse poling when the otter and cooler layers are substantially equally poled.

FIG.1

Xerox Copy Centre

EP 0 309 147 A2

## MONOLITHIC PIEZOELECTRIC BIMORPH

### Background of the Invention

The present invention generally relates to methods for poling remanantly polable piezoelectric ceramics, and particularly concerns a method for producing a piezoelectric bimorph in the form of a monolithic or homogeneous sheet of piezoelectric material.

Certain ceramics such as barium titanate $(BaTiO_3)$ and lead zirconium titanate $(PbZrTiO_3)$ may be poled during manufacture to exhibit piezoelectric properties by the application of a poling field. It is sometimes required to produce what are commonly known as bimorph actuators, which normally comprise a sandwich layer construction of two layers of piezoelectric material, the upper and lower layers being poled in opposite directions and then bonded together. Alternatively, the two layers may be separated by a metal sheet layer so that poling may be performed after bonding. Bimorph actuators are used in flexure and in shear as electro-mechanical transducers.

Laminated piezoelectric bimorphs of the type described above suffer from a number of disadvantages. Initially, they are relatively prone to mechanical deterioration, particularly at the bond layer where stress cracking and fatigue failure may occur. In addition, the bonding procedure itself is a complex operation which is difficult to perform and control in manufacture.

### Objects of the Invention

It is therefore a basic object of the present invention to provide an improved piezoelectric bimorph and a method of manufacturing the bimorph.

It is a further object of the invention to provide a method of manufacturing piezoelectric bimorphs which are highly resistant to mechanical failure.

It is yet another object of the invention to provide a relatively simple yet highly controllable method of manufacturing piezoelectric bimorphs.

These and other objects are achieved according to the invention by providing a novel method of producing a piezoelectric bimorph from a single monolithic or homogeneous sheet of piezoelectric material, the sheet having oppositely poled upper and lower levers and a middle layer which is substantially unpoled. The electrical activity of actuators made by this method is only marginally less than bimorphs made by bonded sheets because the material in the middle layers of the actuator contribute very little in flexure and shear to transducer performance.

### Brief Description of the Drawings

These and other objects and advantages of the invention will be apparent upon reading the following description in conjunction with the drawings, in which:

FIG.1 is a block diagram illustrating apparatus suitable for performing the method of the invention;

FIG.2 graphically illustrates the poling and depoling voltages of a PZT ceramic as a function of temperature;

FIG.3 is a graph showing the temperature gradient applied to a homogeneous sheet of piezoelectric material according to the invention;

FIG.4 is a graph showing the remanent electric displacement characterizing the piezoelectric material after processing according to the invention; and

Figs 5(a), (b) and (c) illustrate the use of a piezo-electric bimorph made according to the invention as a means of providing shear mode actuators for a multi-channel array, electrically pulsed droplet deposition apparatus

### Description of the Preferred Embodiment

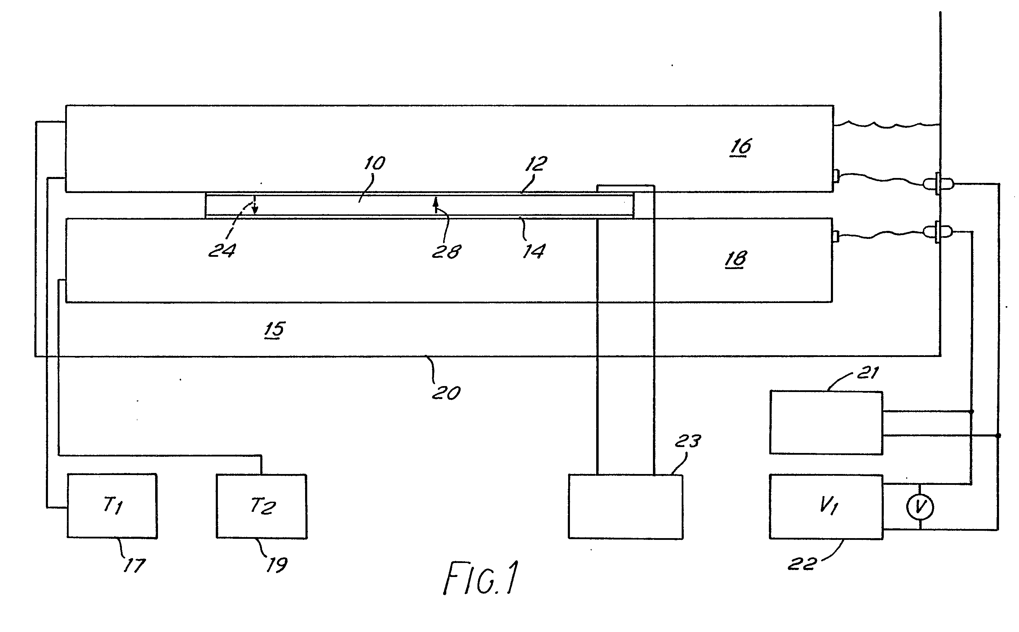

Referring to FIG.1, a sheet 10 of homogeneous or monolithic piezoelectric material such as PZT is provided with upper and lower metalized faces 12 and 14. Sheet 10 is placed between the electrodes 16 and 18 of a poling apparatus 20 so that good electrical contact is made with metalized faces 12 and 14. The electrodes 16 and 18 are preferably immersed in an oil bath 15. Separate temperature controls 17 and 19 are coupled to electrodes 16 and 18 respectively so that each electrode may be independently set to a selected temperature. A voltage supply 22 is coupled across electrodes 16 and 18 for applying an electric field in the range 0-6 volts per micron thickness across sheet 10 on a selected time cycle.

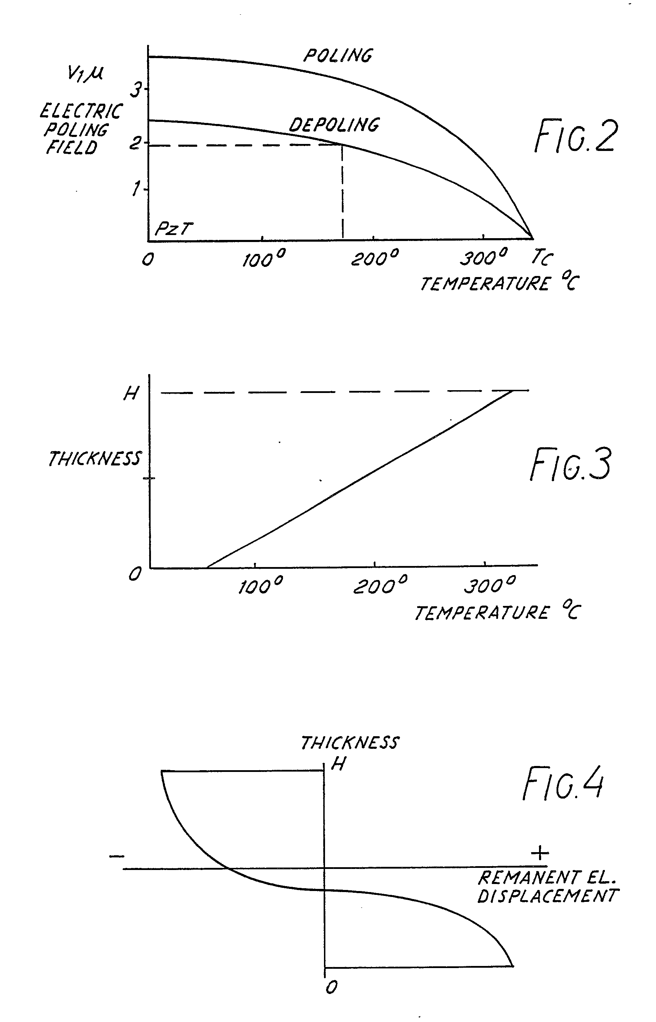

According to the invention, sheet 10 is initially poled through its thickness in a first direction represented by arrow 24. To perform this step, electrodes 16 and 18 are set to a uniform temperature substantially below the Curie temperature of the piezoelectric material comprising sheet 10. The temperature is preferably held in the range between 10-100 degrees centigrade. An electric field is then applied to sheet 10 by electrodes 16 and 18 at a value at or exceeding the poling field of the material comprising sheet 10 at the selected temperature. As indicated by curve 26 of FIG.2, a field of about 3.5 volts per micron is sufficient to pole sheet 10 at 100 degrees centigrade. As is well known in the art, an rf signal may be simultaneously applied to sheet 10 to assist domain reorientation.

Next, the poling field is removed and temperature controls 17 and 19 are operated for setting the electrode temperatures to apply a linear temperature gradient across sheet 10. This is preferably accomplished by heating one electrode, e.g. upper electrode 16 of FIG.1, while allowing lower electrode 18 to fall to a substantially cooler temperature. In particular, as shown in FIG.3, the temperature of upper electrode 16 is raised to a relatively high level not exceeding the Curie temperature of the material, while the temperature of lower electrode 18 is maintained substantially below the Curie temperature, e.g. about 65 degrees centigrade.

A reverse poling field, represented by arrow 28 in FIG. 1, is now applied to electrodes 16 and 18. The magnitude of the reverse field is selected so that the material generally in the middle of sheet 10 becomes depoled. This is accomplished by selecting a field approximately equal to the coercive field of the material at the temperature of the middle portion of the sheet. Typical coercive or depoling fields as a function of temperature for PZT are represented by curve 30 of FIG.2. As shown by curve 30, a larger coercive field is required to depole PZT at lower temperatures. Thus, by selecting the reverse field for depoling the middle sheet 10, the lower portion of the sheet which is cooler consequently remains poled, partially near the middle layers of sheet 10 and completely at the lower metalized face 14. The upper portion of sheet 10, which is substantially hotter, becomes at the same time reverse poled, partially near the middle layers of the sheet and completely at upper metalized face 12 for which the reverse field exceeds the poling field. The magnitude of the reverse field may be found by experiment and will depend on the time for which the field and temperature states are held, as well as the presence of reorientating rf voltage signals applied at the time.

According to one aspect of the invention, a characteristic of PZT sheet 10 is monitored during the reverse poling step to establish the precise time at which reverse poling is terminated. In particular, it is desirable to terminate the reverse poling step when sheet 10 exhibits a net electrical displacement of zero. This may be accomplished by monitoring the impedance of the sheet at its fundamental thickness mode frequency. The reverse poling field is terminated when the net impedance of the sheet reaches zero, since the electrical displacement of the two half's of the sheet cancel at this time. It will be understood that this monitoring technique greatly facilitates automation of the entire bimorph forming process.

In FIG. 1, the monitoring step is performed by applying a high frequency signal (preferably a sweep frequency) from a source 21 across electrodes 16 and 18. The impedance of the sheet is monitored by a phase analyzer 23 coupled across metalized faces 12 and 14. As mentioned above, the reverse poling field is removed when the impedance of sheet 10 at its fundamental thickness mode frequency reaches zero.

Prior to removing the reverse field, the temperature of the upper electrode 16 may be allowed to fall, while the applied field is held substantially constant. The poled state of sheet 10, commonly referred to as the remanent electric displacement, is now of the form illustrated in FIG.4. It will be seen that the upper and lower portions of sheet 10 near electrodes 16 and 18 are at a saturated displacement but that the middle layers are at intermediate states crossing zero. For application as a bimorph actuator in flexure or shear it is the outer layers that principally determine the distribution of stress and strain and the electromechanical moment generated by the piezoelectric actuator. The middle layers contribute relatively less to the performance.

Thus, although the total electric displacement of the bimorph is marginally less than is obtained if two sheets of oppositely poled piezoelectric ceramic are bonded together, the monolithic sheet 10 formed as described is simpler to make and is mechanically more robust. The advantages of mechanical strength and quicker manufacture are believed to offset the small reduction in piezoelectric performance of the actuator.

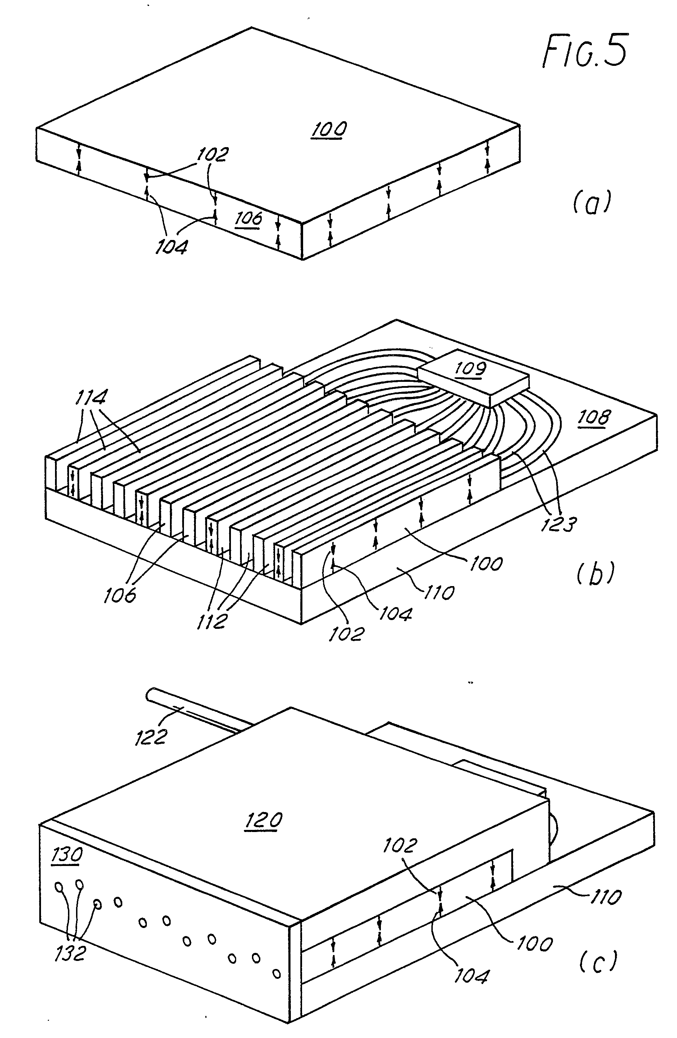

Figures 5(a), (b) and (c) illustrate somewhat diagrammatically the use of a monolithic bimorph piezo-electric sheet in the manufacture of a multi-channel array, electrically pulsed droplet deposition apparatus employing shear mode actuators such as are in general described in co-pending applications Nos. 556136 and 556138 and the disclosures of which are incorporated herein by reference.

Figure 5(a) shows a monolithic piezo-electric bimorph sheet 100 made according to the method herein described having upper and lower layers poled in opposed senses as indicated by arrows 102 and 104. To employ the sheet 100 in the manufacture of a multi-channel array print heat of a pulsed droplet deposition apparatus, the sheet as shown in Fig. 5(b), is first bonded to a first insulating, rigid substrate 110 which extends rearwardly from a front face 106 of the sheet 100 beyond a rear face of said sheet to form a ledge 108 on which a silicon driver ship 109 is mounted. Parallel channels 112 are next cut in the sheet 100 which are defined by bimorph walls 114 and the substrate 110. The channels 112 can be cut to the depth of of the substrate or can extend through the sheet 100 and into the substrate. Metallised electrodes (not shown) are now deposited by vacuum sputtering to cover the interior surfaces of the channels.

Surplus metal deposited on surfaces of the walls 114 parallel with the substrate 110 and end surfaces thereof is removed by lapping. A second rigid insulating substrate 120 facing the substrate 110 is now secured to the walls 114 to define with said walls 114 and substrate 110, the channels 112. A droplet liquid supply 122 is provided in the second substrate which connects with open rear ends of the channels 112.

To the metallised electrodes lining the respective channels 112 are connected metallised tracks 123 on the upper surface of the ledge 108 which connect the electrode linings to the driver chip 109. Finally, there is bonded to the front surfaces 106 of the bimorph walls and the front surface of substrate 110 which is coplanar with the surfaces 106, a nozzle plate 130 in which are provided nozzles 132 which respectively connect with the channels 112. It will be apparent that the bimorph walls thus provide chevron type shear mode actuators such as are described and illustrated in said co-pending patent applications, see, for example. Fig. 1 of Application 556136 and Fig. 2(a) of Application 556138.

It will be understood that the invention may be embodied in other specific forms without departing from the spirit or central characteristics thereof. The present examples and embodiments, therefore, are to be considered in all respects as illustrative and not restrictive, and the invention is not to be limited to the details given herein.

**Claims**

1. A method of manufacturing a piezoelectric bimorph comprising the steps of:
uniformly poling a homogeneous sheet of piezoelectric material through its thickness in a first poling direction;
establishing a substantially linear temperature gradient across the thickness of said sheet;
concurrently applying a poling field across the thickness of said sheet having a direction and magnitude selected for substantially depoling the middle layers of said sheet, poling the hotter layers of said sheet in a direction reverse that of said first direction and leaving the cooler layers of said sheet poled in said first direction; and
removing the temperature gradient and poling field from the sheet.

2. The method of claim 1 including monitoring a characteristic of said sheet to determine when said hotter and cooler layers are substantially equally poled and performing said removing step in response thereto.

3. The method of claim 1 wherein said uniform poling step comprises holding said sheet at a first temperature substantially below its Curie temperature and applying an electric field across the thickness of said sheet in said first direction of a magnitude sufficient at said first temperature to uniformly pole said sheet through its thickness.

4. The method of claim 3 wherein said first temperature is in the range of 10-100 degrees centigrade.

5. The method of claim 3 wherein said establishing step comprises raising and holding one face of said sheet at a relatively high temperature not exceeding the Curie temperature of said piezoelectric material and holding the opposite face of said sheet at a temperature substantially below the Curie temperature of said piezoelectric material.

6. The method of claim 5 wherein said concurrently applying step comprises applying said poling field across the thickness of said sheet in a direction reverse that of said first direction and at a magnitude corresponding to the coercive field of said material at the temperature established in the middle layers of said sheet.

7. The method of claim 6 wherein said removing step comprises lowering the temperature of said one face while holding the reverse poling field substantially constant and then subsequently removing the reverse poling field.

8. A method of manufacturing a piezoelectric bimorph comprising the steps of:
maintaining a homogeneous sheet of piezoelectric material at a first temperature substantially below its Curie temperature while applying an electric field across the thickness of said sheet in a first direction and of a magnitude sufficient at said first temperature to uniformly pole said sheet through its thickness;
removing said electric field from said sheet;
establishing a substantially linear temperature gradient across the thickness of said sheet;
concurrently with said establishing step, applying a second poling field across the thickness of said sheet in a direction reverse that of said first direction and at a magnitude corresponding to the coercive field of said material at the temperature established in the middle layers of said sheet; and
removing the temperature gradient and second poling field from said sheet.

9. The method of claim 8 including monitoring a characteristic of said sheet to determine when its upper and lower layers are substantially equally poled and performing said removing step in response thereto.

10. The method of claim 8 wherein said establishing step comprises raising and holding one face of said sheet at a relatively high temperature not exceeding the Curie temperature of said piezoelectric material while holding the opposite face of said sheet at a temperature substantially below the Curie temperature of said material.

11. The method of claim 8 wherein said first temperature is in the range of 10-100 degrees centigrade.

12. The method of claim 8 wherein said removing step comprises lowering the temperatures of said one face while holding said second poling field substantially constant and then subsequently removing said second poling field.

13. A bimorph comprising a homogeneous sheet of piezoelectric material having a middle layer, a first outer layer extending from the middle layer to one surface of said sheet and a second outer layer extending from the middle layer to the opposite surface of said sheet, the first and second layers being poled in opposite directions and said middle layer being substantially unpoled, said poling characteristics being established by uniformly poling a homogeneous sheet of piezoelectric material through its thickness in a first poling direction, establishing a substantially linear temperature gradient across the thickness of said sheet, concurrently applying a poling field across the thickness of said sheet having a direction and magnitude selected for substantially depoling the middle layers of said sheet, poling the hotter layers of said sheet in a direction reverse that of said first direction and leaving the cooler layers of said sheet poled in said first direction, and removing the temperature gradient and poling field from the sheet.

14. The bimorph of claim 13 wherein said first and second layers are substantially equally poled.

15. The bimorph of claim 14 wherein said first and second substantially equally poled layers are produced by monitoring a characteristic of said sheet to determine when said first and second layers are substantially equally poled and performing said removing step in response thereto.

16. The bimorph of claim 13 wherein said poling characteristics are further established by holding said sheet at a first temperature substantially below its Curie temperature and applying an electric field across the thickness of said sheet in said first direction of a magnitude sufficient at said first temperature to uniformly pole said sheet through its thickness.

17. The bimorph of claim 16 wherein said poling characteristics are further established by performing said establishing step by raising and holding one face of said sheet at a relatively high temperature not exceeding the Curie temperature of said piezoelectric material and holding the opposite face of said sheet at a temperature substantially below the Curie temperature of said piezoelectric material.

18. The bimorph of claim 17 wherein said poling characteristics are further established by performing said concurrently applying step by applying said poling field across the thickness of said sheet in a direction reverse that of said first direction and at a magnitude corresponding to the coercive field of said material at the temperature established in the middle layers of said sheet.

19. The bimorph of claim 18 wherein said poling characteristics are further established by performing said removing step by lowering the temperature of said one face while holding the reverse poling field substantially constant and then subsequently removing the reverse poling field.

20. A high density multi-channel array pulsed droplet deposition apparatus, comprising a sheet of piezo-electric material, a first substrate to which said sheet is bonded, said sheet of piezoelectric material being formed with a multiplicity of parallel open topped channels mutually spaced in an array direction normal to the length of said channels and defined each by facing side walls and a bottom surface extending between said side walls, and a second substrate facing said first substrate and bonded to said side walls to close said channels at the open tops thereof, said side walls each comprising a monolithic piece of piezo-electric material having two oppositely poled layers respectively adjacent said first and second substrates, respective nozzles communicating with said channels for the ejection of droplets therefrom, connection means for connecting said channels with a source of droplet deposition liquid and electrodes provided on opposite sides of each of some at least of said side walls to form shear mode actuators for effecting droplet expulsion from the channels associated with said actuators.

21. Apparatus as claimed in Claim 20, characterised in that the layers of oppositely poled piezoelectric material are of substantially the same thickness in the direction of poling.

22. Apparatus as claimed in Claim 20 or Claim 21, characterised in that said channels extend into said first substrate.

23. The method of manufacturing a high-density multi-channel array pulsed droplet deposition apparatus, characterised by forming a monolithic sheet of piezo-electric material with upper and lower layers poled in opposite senses normal to said sheet, bonding said lower layer to a first substrate, forming a multiplicity of parallel, open topped channels in said sheet mutually spaced in an array direction normal to the length of said channels and defined each by facing side walls and a bottom surface extending between said facing side walls, said side walls each comprising a monolithic piece of piezo-electric material having oppositely poled upper and lower layers of which said lower layer is bonded to said first substrate, forming electrodes on opposite sides of each of some at least of said side walls to form shear mode actuators for effecting droplet deposition from the channels associated with said actuators, bonding a second substrate to said side walls facing said first substrate, providing nozzles respectively communicating with said channels provided with said actuators at corresponding ends thereof and providing connection means for connecting a source of droplet liquid to said channels.

24. The method claimed in Claim 23, characterised by forming said upper and lower layers of the same thickness in the direction of poling.

25. The method claimed in Claim 22 or 23, characterised by forming said channels to extend into said first substrate.

FIG.1

FIG.2

FIG.3

FIG.4

FIG.5

(a)

(b)

(c)